# EUROPEAN PATENT APPLICATION

(11) **EP 4 787 006 A1**
(43) Date of publication of application: **05.08.2026**
(21) Application number: 25155007.5
(22) Date of filing: 30.01.2025
(51) Int. Cl.: G01R 33/56, G01R 33/563

(54) **MAGNETIC RESONANCE IMAGING USING CEST AND DIFFUSION CONTRASTS**

(71) Applicant: Koninklijke Philips N.V., 5656 AE Eindhoven (NL)
(72) Inventor: KEUPP, Jochen, Eindhoven (NL); VAN DEN BRINK, Johan Samuel, Eindhoven (NL)
(74) Representative: Philips Intellectual Property & Standards

(57) **Abstract**

Methods and systems for magnetic resonance imaging at least a part of a body are presented. The method comprises: acquiring signals by subjecting the portion of the body (10) to first and second contrast encoding elements within one repetition time (TR) of a sequence, wherein the first contrast encoding elements comprise chemical exchange saturation transfer (CEST) information encoding and the second contrast encoding elements comprise diffusion information encoding; deriving CEST information based on the signals associated with the first contrast encoding elements; deriving diffusion information based on the signals associated with the second encoding elements; and outputting the CEST information and the diffusion information. The system comprises a computational system (15) configured to perform the method.

## Description

### FIELD OF THE INVENTION

The invention relates to the field of magnetic resonance imaging. It concerns a method of magnetic resonance imaging, a magnetic resonance imaging system and a computer program for a magnetic resonance imaging system.

### BACKGROUND OF THE INVENTION

Image-forming magnetic resonance (MR) methods that utilize the interaction between magnetic fields and nuclear spins in order to form two-dimensional or three-dimensional images are widely used nowadays, notably in the field of medical diagnostics, due to their superiority for imaging soft tissue to other imaging methods, mainly because of not requiring ionizing radiation and being usually not invasive.

In some medical applications, the difference in MR signal intensity from standard magnetic resonance imaging (MRI) protocols, i.e. the contrast between different tissues, might not be sufficient to obtain satisfactory clinical information. In this case, contrast enhancing techniques are applied. An approach for contrast enhancement and for increasing MR detection sensitivity (by orders of magnitude) is the known method based on Chemical Exchange Saturation Transfer (CEST), as initially described by Balaban et al. in US 2008/0167549 A1. With this CEST technique, the image contrast is obtained by altering the intensity of the water proton signal in the presence of a contrast agent or an endogenous molecule with a proton pool resonating at a different frequency than the main water resonance. This is achieved by selectively saturating the nuclear magnetization of the pool of exchangeable protons that resonate at a frequency different from the water proton resonance. Exchangeable protons can be provided by exogenous CEST contrast agents (e.g., DIACEST, PARACEST or LIPOCEST agents), but can also be found in biological tissue (i.e. endogenous amide protons in proteins and peptides, protons in glucose or protons in metabolites like choline or creatinine). A frequency-selective saturation radiofrequency (RF) pulse that is matched to the MR frequency of the exchangeable protons is used for this purpose. The saturation of the MR signal of the exchangeable protons is subsequently transferred to the MR signal of nearby water protons within the body of the examined patient by chemical exchange with the water protons, thereby decreasing the water proton MR signal. The selective saturation at the MR frequency of the exchangeable protons thus gives rise to a negative contrast in a proton-density weighted MR image.

Amide proton transfer weighted (APTw) MR imaging, which is a CEST technique based on endogenous exchangeable protons, allows highly sensitive and specific detection of pathological processes on a molecular level, like increased protein concentrations in malignant tumor tissue. The APT signal is also sensitively reporting on locally altered pH levels, because the exchange rate is pH dependent, which can for example be used to characterize ischemic stroke. APTw CEST MR imaging has several advantages over conventional MR contrasts with or without contrast agents. It allows highly specific detection and differentiation of exogenous and endogenous contrasts, which is much more sensitive than for example spectroscopic MR or NMR techniques. This high sensitivity (signal to noise ratio, SNR, efficiency) can be used to obtain molecular contrast information at a resolution comparable to typical MR imaging applications in clinically acceptable examination times.

Diffusion-weighted magnetic resonance imaging (DWI) provides information on the diffusivity of water molecules in the human body. Technological advances and the development of the concept of diffusion-weighted whole-body imaging with background body signal suppression (DWIBS) have opened the path for routine clinical whole-body DWI. Whole-body DWI allows detection and characterization of both oncological and non-oncological lesions throughout the entire body. Kwee TC, et al., Whole-body diffusion-weighted magnetic resonance imaging; Eur. J. of Radiol. 2009; 70(3):409-17; doi:10.1016/j.ejrad.2009.03.054 reviews the basic principles of DWI and the development of whole-body DWI, illustrates its potential clinical applications, and discusses its limitations and challenges.

Cervical MR scanning of patients performed by using a 3T system with an external pelvic phased array coil is disclosed in Li S, et al., Added-value of 3D amide proton transfer MRI in assessing prognostic factors of cervical cancer: a comparative study with multiple model diffusion-weighted imaging; Quant Imaging Med Surg. 2023;13(12):8157-8172; https://dx.doi.org/10.21037/qims-23-324. Measurements have been acquired separately by using various sequences, such as: axial T2-weighted turbo spin echo (TSE) imaging, diffusion-weighted imaging (DWI), and APT imaging. APT imaging was conducted using an optimized 3D TSE pulse sequence combined with chemical shift-selective fat suppression for better robustness to field inhomogeneity and 3D volume coverage. DWI was acquired via a single-shot echo-planar imaging (EPI) sequence for various b-values with diffusion gradients applied simultaneously along three orthogonal directions. Results indicate that APT imaging in addition to DWI may improve the ability to noninvasively predict poor prognostic factors of cervical cancer.

### SUMMARY OF THE INVENTION

An object of the invention is to provide an improved MR imaging method enabling efficient scanning as well as to provide an MR system configured to carry out the method.

According to the invention, a method of MR imaging of at least a portion of a body is provided, comprising:
acquiring signals by subjecting the portion of the body to first and second contrast encoding elements within one repetition time (TR) of the sequence, wherein the first contrast encoding elements comprise chemical exchange saturation transfer (CEST) information encoding, and the second contrast encoding elements comprise diffusion information encoding;
deriving CEST information based on the signals associated with the first contrast encoding elements;
deriving diffusion information based on the signals associated with the second contrast encoding elements; and
outputting the CEST information and the diffusion information.
Simultaneous acquisition of CEST and diffusion information ensures that the slice locations are identical, for example if a breath holding or breathing gating is applied. It further obviates the need for a registration step and facilitates the use of CEST to steer geometry correction of the EPI distortions of the diffusion part.

In some of the embodiments, the second contrast encoding elements are integrated during a delay time after the first contrast encoding elements within the one repetition time of the sequence, which delay time is necessary for T1 relaxation recovery and to ensure operation within specific absorption rate (SAR) constraints. These physics constraints impose non-encoding time to a sequence with only CEST encoding elements, and inherently reduce sampling efficiency. The diffusion contrast encoding elements do not substantially deposit SAR, and can be interleaved with the CEST contrast encoding elements. This is beneficial for multi-slice sequences (addressing the same or different slices for CEST and DWI) as well as for 3D. Even when inserting diffusion encoding for the same slice or volume in the time period for T1 relaxation delay, the effect of the previous RF saturation is efficiently relaxed.

In some embodiments at least a portion of one of the first contrast encoding elements at least partially overlaps in timing with at least a portion of one of the second contrast encoding elements. The first (e.g., CEST) encoding elements comprise: RF saturation pulses (of any shape like block, gaussian or hypersecant) or pulse trains (100% RF duty cycle, any shape) with variable frequency offset and B1rms level, RF pulse trains as before with reduced (<100%) RF duty cycle; whereas the second (e.g., diffusion) encoding elements comprise: single gradient pulses (variable amplitude and duration), composite gradient pulses (i.e. bipolar gradients, variable amplitude, duration, GR duty cycle), oscillating gradients (variable frequency, amplitude, duration).

In some of the embodiments, each repetition time comprises multiple repetitions of diffusion information encoding. Since CEST information encoding requires multiple Z-spectral offsets, the T1 relaxation delay is long enough, therefore multiple b-values of diffusion encoding or multiple averages of one b-value can be inserted within one repetition time of the sequence. This may further increase the time efficiency of the combination.

The CEST information encoding may comprise CEST saturation, which may be at different saturation frequency offsets (Z-frequencies) and/or at different saturation levels (B1rms level of the saturation pulse) for subsequent sequences.

In some of the embodiments, the diffusion information encoding comprises diffusion weighting gradients, the CEST information encoding comprises off-resonance radiofrequency saturation for CEST contrast preparation, and the diffusion weighting gradients may be integrated into pulsed off-resonance radiofrequency (RF) saturation for CEST contrast preparation. In an embodiment of 3D acquisition, a diffusion gradient can be used for a (slice) location dependent RF saturation at the same time, then cycling through different RF saturation frequencies to complete Z-spectra independently for each slice location.

The diffusion weighting gradients may be implemented as block gradient pulses in multiple directions and/or of different strengths or elements of an oscillating gradient. The implementation may use gradients with constant amplitude over typically 20-30 ms or with varying amplitudes such as a 5-7 period sine wave over 30 ms. Oscillating gradients improve the sensitivity to diffusion path length scales. The diffusion encoding gradients can have different encoding orientations in space. The amplitudes of the encoding can also vary to adapt the diffusion encoding sensitivity.

In some of the embodiments, the diffusion information encoding comprises spoiler gradient used to spoil transverse magnetization from the on-resonance radiofrequency excitation for the CEST signal acquisition associated with the CEST information encoding including off-resonance radiofrequency saturation. The spoiler strength can be varied for different diffusion weighting. This allows acquiring a diffusion-weighted reference image (on-resonance in the Z-spectrum, or rather, unsaturated), in which case there's no EPI related distortion and the diffusion weighted image used as mask in visualization is at the same geometry as the CEST image.

In some of the embodiments, outputting the CEST information and the diffusion information comprises diffusion information-based masking of CEST information, or CEST-based masking of diffusion information. Diffusion images are very sensitive, i.e. show all lesions, but sometimes too many, therefore, masking with the highly specific CEST image removes the false positives. Alternatively, the CEST data is often difficult to read due to high background signals in the processed images, i.e. when basically arbitrary signals are mixed, hence the diffusion mask can remove these irrelevant background pixels.

The outputting may comprise displaying and/or evaluating CEST information only in anatomical areas where diffusion information is indicative of lesion or abnormality, or displaying and/or evaluating diffusion information only in anatomical areas where CEST information is indicative of lesion. This improves ease-of-use in reading combined CEST and diffusion information.

In some of the embodiments, outputting the CEST information and the diffusion information comprises a composite metric based on the CEST information and the diffusion information.

In any of the embodiments, the CEST information may be amide proton transfer weighted (APTw) information.

In any of the embodiments, the diffusion information may be any of diffusion weighted imaging (DWI) information, diffusion weighted imaging with background suppression (DWBIS), apparent diffusion coefficient (ADC) and diffusion kurtosis imaging. Tissue malignancy is associated with low (diffusion coefficient) ADC (typically < 0.4), whereas high ADC (typically > 1.3) is associated with free fluid. Hence, a composite metric such as for example dividing the CEST percentage by ADC or ADC squared, can mix ADC's sensitivity into CEST's specificity in a single image. Same holds for the kurtosis metric from diffusion, though it displays less variation. In another instant, a reference ADC or kurtosis value can be assigned to normal and the (relative) deviation from normal used to scale CEST percentage.

In some of the embodiments, outputting the CEST information and the diffusion information comprises radiomics analyses on lesions, based on combined CEST information and the diffusion information, e.g., radiomics analysis of the CEST weighted images and of the diffusion weighted images. Radiomics features such as characteristic length scales for the two contrasts can be compared on a pixel-by-pixel basis since the data is acquired at the same location without further processing, because registration may negatively affect the radiomics analytics.

The method of the invention described thus far can be carried out by means of an MRI system including at least one main magnet coil for generating a uniform steady magnetic field within an examination volume, a number of gradient coils for generating switched magnetic field gradients in different spatial directions within the examination volume, at least one radiofrequency (RF) coil for generating RF pulses within the examination volume and/or for receiving MR signals from the body of a patient positioned in the examination volume, a control unit for controlling the temporal succession of RF pulses and switched magnetic field gradients, and a reconstruction unit for reconstruction of an MR image from the received MR signals. The method of the invention is preferably implemented by corresponding programming of the control unit and/or the reconstruction unit of the MRI system.

Any of the embodiments of the method according to the invention can be advantageously carried out by a system in most MR environments in clinical use at present. To this end it is merely necessary to utilize a computer program on a computer (e.g., a PC), comprised by the system, to operate an MRI system and to perform any of the method embodiments according to the invention. The computer program may be present either on a data carrier or be present in a data network so as to be downloaded for installation, e.g., into the control unit or the reconstruction unit of an MR system.

### BRIEF DESCRIPTION OF THE DRAWINGS

The enclosed drawings disclose preferred embodiments of the present invention. It should be understood, however, that the drawings are for the purpose of illustration only and not as a definition of the limits of the invention. In the drawings:
Fig. 1 shows an MR system according to the invention;
Fig. 2 shows an imaging sequence according to the invention;
Fig. 3 shows a further imaging sequence according to the invention;
Fig. 4 shows yet a further imaging sequence according to the invention;
Fig. 5 shows a further variant of an imaging sequence according to the invention;
Fig. 6 shows a flow chart illustrating a method according to the invention;
Fig. 7 shows comparative results of the invention with respect to separate APTw and DWI acquisition sequences;
Fig. 8 shows further exemplary results obtained with a method embodiment according to the invention.

### DETAILED DESCRIPTION OF THE EMBODIMENTS

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alterations and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a computer implemented method and/or in a computer program product, in a corresponding manner.

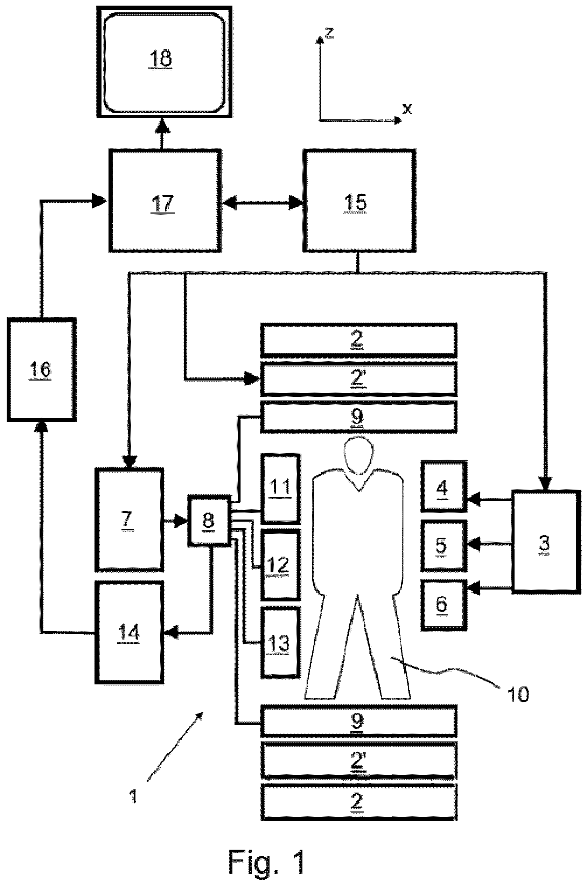

With reference to Fig. 1, an MRI system 1 is shown. The device comprises superconducting or resistive main magnet coils 2 such that a substantially uniform, temporally constant main magnetic field B₀ is created along a longitudinal z-axis through an examination volume. The device further comprises a set of (1^{st}, 2^{nd}, and - where applicable - 3^{rd} order) shimming coils 2', wherein the current flow through the individual shimming coils of the set 2' is controllable for the purpose of minimizing B₀ deviations within the examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient pulse amplifier 3 applies current pulses to selected ones of whole-body gradient coils 4, 5 and 6 along x, *y* and z-axes of the examination volume. A digital RF frequency transmitter 7 transmits RF pulses or pulse packets, via a send-/receive switch 8, to a body RF coil 9 to transmit RF pulses into the examination volume. A typical MR imaging sequence is composed of a packet of RF pulse segments which, together with any applied magnetic field gradients, achieve a selected manipulation of nuclear magnetic resonance. The RF pulses are used to saturate, excite resonance, invert magnetization, refocus resonance, or manipulate resonance and select a portion of a body 10 positioned in the examination volume. The MR signals are also picked up by the body RF coil 9. Any of the MR imaging sequences according to the invention, as well as other MR imaging sequences known in the art or protocols may be stored in a memory. The memory is intended to represent any combination of memory or storage device which is accessible to a computational system configured to control the MR acquisition and/or reconstruction. The memory may include volatile and non-volatile memory storage means and components. The memory in some embodiments may be based on or may rely on cloud-based data stored in logical pools across disparate, commodity storage servers located on premises or in a data center managed by a third-party cloud provider.

For generation of MR images of limited regions of the body 10 by means of parallel imaging, a set of local array RF coils 11, 12, 13 are placed contiguous to the region selected for imaging. The array coils 11, 12, 13 can be used to receive MR signals induced by body-coil RF transmissions.

The resultant MR signals are picked up by the body RF coil 9 and/or by the array RF coils 11, 12, 13 and are demodulated by a receiver 14, preferably including a preamplifier (not shown). The receiver 14 is connected to the RF coils 9, 11, 12 and 13 via send-/receive switch 8.

The RF body coil or other segmented coils, such as the local array RF coils may comprise multiple RF transmission channels. They may use a special configuration with different transmission channel settings for RF saturation and imaging RF pulses.

A computer system or with other words a host computer 15 controls the shimming coils 2' as well as the gradient pulse amplifier 3 and the transmitter 7 to generate any of a plurality of MR imaging protocols, such as for example echo planar imaging (EPI), echo volume imaging, gradient and spin echo imaging, fast spin echo imaging, and the like. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. The digital raw image data may be stored in the memory. In modern MR devices the data acquisition system 16 is a separate computer, which is specialized in the acquisition of raw image data.

The digital raw image data is used for generating or reconstructing an image representation by a reconstruction processor 17, which applies a Fourier transform and/or other appropriate reconstruction algorithms, such as SENSE, GRAPPA, Compressed Sensing (CS), artificial intelligence (AI)-augmented CS, end-to-end machine learning (ML), generative AI, any of the CS methods along with CEST encoding dimension, combination of all k-space inputs into CEST and diffusion (e.g., DWI, ADC) image data and/or combined maps. Generating the MR image can be based on algorithms stored in cloud-based memory, to which the raw image data is transmitted and the cloud-based computing system may perform the image reconstruction. The MR image is then transmitted back to the MRI system and/or to a separate display device such a display screen, a tablet, smartphone, etc. The MR image may represent a planar slice through the patient, an array of parallel planar slices, a three-dimensional volume, or the like. The MR image may then be stored in a memory where it may be accessed for converting slices, projections, or other portions of the image representation into appropriate format for visualization on a display screen 18 for presenting the information in user-readable manner. In some embodiments the functionalities of the host computer 15, the data acquisition system 16 and the reconstruction processor 17 are implemented in one computer system.

Without limitation by any of the features disclosed with reference to Fig. 1, the MRI system may comprise any further elements that allow use of any of the methods disclosed in US 2013/0342207 A1, which is incorporated herein by reference in its entirety.

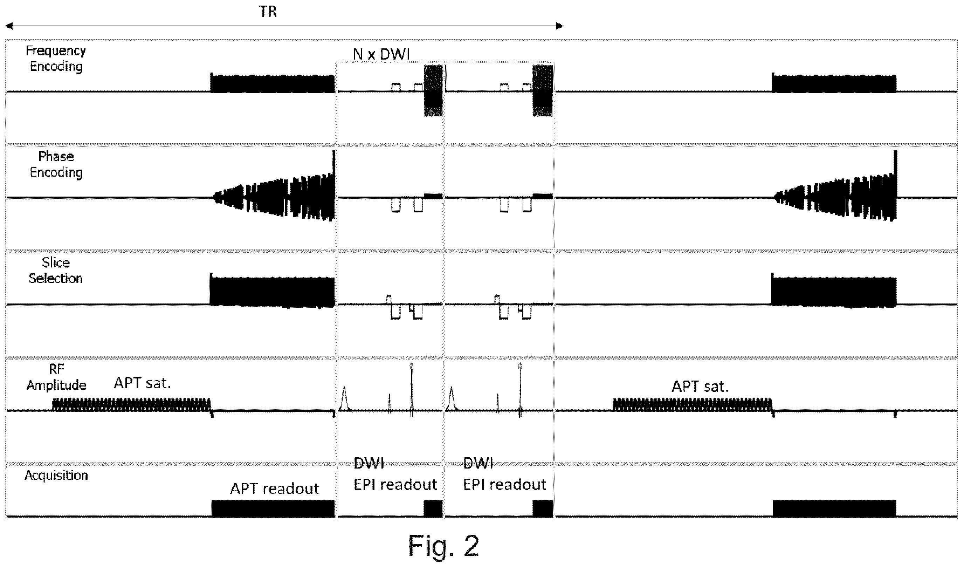

With reference to Fig. 2, an exemplary sequence for MR imaging is presented, according to the invention. In this embodiment APTw is used as a specific type of CEST MRI, using a saturation frequency offset of +3.5ppm, but the disclosed technique is applicable to any type of CEST MRI. The APTw contrast encoding and diffusion information (DWI) encoding are combined in a single acquisition sequence, which can for example be applied locally for specific organ and/or lesions or throughout the body in a whole-body acquisition. A single acquisition sequence refers to a sequence with the duration of a single repetition time (TR), which is the (longest) duration between subsequent excitations of the same body slice associated with data collection for a section of k-space encoding the first or second contrast information, meaning according to the invention that during the duration of a single TR the sequence comprises APT and diffusion contrast encoding elements, and based on the repeated acquisition of the MRI data with such sequence for all required sections of k-space, APTw and DWI images or further images derivable therefrom can be obtained. TR may also be understood as the time elapsed before a next section of k-space for the same excited volume is acquired, with identical CEST or diffusion contrast weightings.

In principle, there are several possibilities to design an acquisition sequence to acquire APTw and DWI information together, which thus basically does not necessitate extra scanning time. For this aim, DWI sequence elements may be inserted in an APTw sequence or APTw sequence elements may be inserted into DWI sequences.

In a first embodiment denoted with (a) and illustrated in Fig. 2, parts of diffusion contrast encoding elements (e.g., of DWI) are integrated into the delay time of the APTw contrast encoding, which is needed for relaxation recovery and specific absorption rate (SAR) cooldown. The illustrated sequence consists of the RF saturation ("APT sat."), which is acquired in multiple steps (Z-spectrum) at and around the nominal CEST off-resonance frequency (+3.5ppm for APTw). Compared with MR signals acquired without RF saturation, the signal reductions at certain saturation frequency offsets derive not only from the CEST effect, but also from direct saturation of the water protons and, moreover, from magnetization transfer from semisolid macromolecules during in-vivo imaging. Direct saturation and also magnetization transfer can be assumed to cause signal reductions that are symmetrical with respect to the resonance frequency of water protons. In conventional CEST MR imaging, therefore, the effect of the saturation transfer of exchangeable protons to water is conventionally identified for each image voxel by an asymmetry analysis of the amplitude of the acquired MR signals as a function of the saturation frequency offset, the so-called Z-spectrum.

A Z-spectrum is typically beneficial to perform B₀ correction to compensate for magnetic field inhomogeneity in asymmetry analysis (MTR_{asym} = APTw signal). Alternatively, the Z-spectrum may be used for a model fitting approach for the background signal (magnetization transfer effect, direct water saturation, fat signal content etc.). The model fitting may also include components for the APT pool (exchanging protons at +3.5 ppm) directly to extract the signal. The APT readout could be any MRI acquisition, in this example a fat-saturated fast spin echo approach is taken using a low-high radial cartesian 3D k-space order.

Between the APT readout (which could be any acquisition type, including spin echo, gradient echo, combined spin and gradient echo, or echo planar) and a subsequent APT saturation module (APT sat.), a long delay is needed (in this example about 2.5 seconds) for relaxation (T1) and SAR cooldown. Subsequent APT saturation in the sequence may be at different Z-frequencies and/or for different saturation levels. In this delay period of the APT encoding element, N repetitions of DWI encoding elements can be placed, in this example by using a single shot spin-echo EPI sequence. For example, each repetition of the diffusion contrast encoding element (acquisition of one b-value, one average) takes 350 ms, such that 2 b-values can be acquired for 3 slices (2.1 sec in total) interleaved into the APTw/CEST sequence without spending any extra scan time for the DWI information.

The gradient echo or spin echo sequences used for DWI have no average effect on the saturation recovery time for the previous (off-resonant) RF saturation pulse. With comparatively long TR (including the diffusion weighting gradient pulse), the SAR contribution of the DWI sequence is small. Gradient effects from the DWI inserted sequence like eddy-currents, spatially deforming the magnetic field uniformity, will not influence the subsequent APTw acquisition, because there is sufficient time during the RF saturation pulse to relax those.

In a second embodiment denoted with (b) and leveraging gradient echo type sequences, and which is alternative to (a), diffusion weighting gradients are integrated into pulsed RF saturation during APTw contrast preparation. This may for example be block gradient pulses in multiple directions and/or of different strengths or elements of an oscillating gradient (with alternating amplitudes, predetermined strength and oscillation frequencies).

In a third embodiment denoted with (c), which is alternative to (a) and (b), different diffusion weighting is induced during an APTw sequence by varying the spoiler gradient area of the gradient echo sequence used to spoil transverse magnetization from the RF saturation pulse, and/or the spoiler gradient strength necessary to eliminate any residual coherences of transverse magnetization that would cause image artifacts in a subsequent readout of a subsequent TR of the gradient echo sequence. Such spoiler gradients are always necessary, where the variation in strength in this embodiment is achieved by varying the area of the crusher by either varying the duration or varying the strength, or both.

In a fourth embodiment denoted with (d), which is alternative to (a), (b) and (c), RF saturation is added for APTw contrast preparation in parts of a single-shot or multi-shot DWI sequence (e.g., with echo planar readout).

In a fifth embodiment denoted with (e), which is alternative to (a), (b), (c) and (d), DWI is combined with steady-state APTw weighting in a short repetition time (TR) steady-state sequence (e.g., with gradient echo readout), where in each TR a short (e.g., single pulse) RF saturation and a diffusion weighting gradient is placed before the signal acquisition. RF saturation builds up over time to form a strong steady-state saturation level (if TR << T1).

In some embodiments, any of the combined APTw-DWI sequence implementations according to embodiments (a) to (e) may infer magnetic field homogeneity (B₀ map) for signal correction from the same combined scan (e.g., using a Dixon-type APT readout to simultaneously provide a B₀ map and/or fat-water information) or include B₀ map data from a separate sequence acquisition. The B₀ map is advantageously used to correct the Z-spectrum and to provide information for geometry correction of the DWI EPI readouts.

Additionally, any of the above embodiments may use diffusion weighting only in parts of the APTw Z-spectral acquisition and different diffusion weighting for different parts of the Z-spectral acquisition.

Further, any of the above embodiments may use diffusion weighting in parts of a APTw acquisition with different RF saturation levels (B1rms and/or overall pulse duration).

While applicable in a single body location, it can be advantageous to concatenate sets of images from multiple sequences acquired at different body landmarks and having each combined APT and DWI readouts in a multi-station approach throughout the body, wherein multi-station refers to using a series of MRI sequences at different (adjacent) table positions to achieve a larger FOV or whole-body coverage, conform Summers P, et a., Whole-body magnetic resonance imaging: technique, guidelines and key applications; Ecancermedicalscience;15:1164; doi: 10.3332/ecancer.2021.1164, which is herewith incorporated by reference in its entirety. Per station, dedicated extensions can be used to compensate for motion and tissue fat contents.

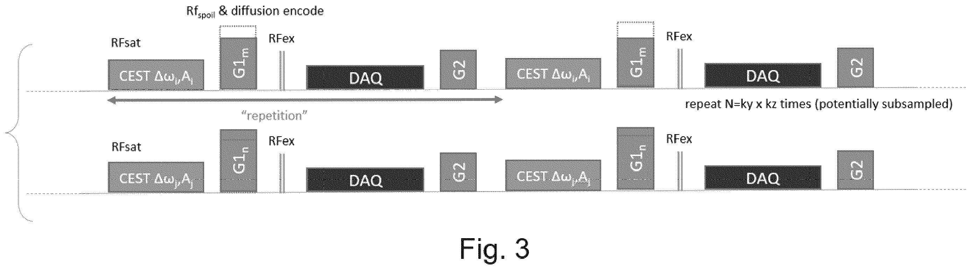

In Fig. 3 a further imaging sequence according to the invention is illustrated, in which CEST Δωᵢ,Aᵢ and CEST Δωⱼ,Aⱼ are RF saturation modules covering the Z-spectrum at multiple off-resonance frequencies Δω (typically between -400 kHz and + 400 kHz) and different RF amplitudes A (leading to different B1rms levels, typically 1-2 µT); G1ₘ and G1ₙ are first crusher gradient pulses with different amplitudes; DAQ is the imaging data acquisition module using the MR receiver ADC (analog digital converter) and including all necessary gradients for covering k-space (frequency and phase encoding); G2 is a second crusher gradient to eliminate transverse magnetization coherences and prevent image artifacts from spurious echo formation in subsequent DAQ window; RFsat is the module to generate the CEST effect; RFex is an excitation pulse to generate the transverse magnetization for capturing the image data in k-space. The two lines are for illustration purposes only, which is somewhat a hybrid between less abstraction or detailing out all examples of steps i, j, k, l and the full abstraction of only showing i and assuming that an abstract mind understands that this translates in many different instantiations of amplitudes. Each repetition time (TR) has CEST and diffusion contrast encoding elements. meaning according to the invention that during the duration of a single TR the sequence comprises CEST and diffusion contrast encoding elements, and based on the repeated acquisition of the MRI data with such sequence for all required sections of k-space, APTw and DWI images or further images derivable therefrom can be obtained. TR may also be understood as the time elapsed before a next section of k-space for the same excited volume is acquired, with identical CEST or diffusion contrast weightings.

In order to complete Z-spectra and different diffusion weightings, several variants are completed. Turning down CEST saturation or diffusion encoding to zero is just one special case of this variation.

For G1, the amplitude, duration or shape can be varied. For CEST, the RF saturation off-resonance (Δωj) and amplitude (Aⱼ) may be varied. Filling the k-space can be subsampled for each variant. Subsampling can be different for each variant and joint reconstruction can be applied, for example by using compressed sensing. In this embodiment according to the invention, there is only one DAQ element per repetition time which records data with combined CEST and diffusion encoded data. The DAQ element can constitute one k-space line or MR echo or multiple k-space lines like in EPI, spiral, Propeller or radial k-space coverage schemes. Using the same DAQ to acquire CEST and diffusion encoded data will lead to enhanced precision of the geometrical alignment of the two data types.

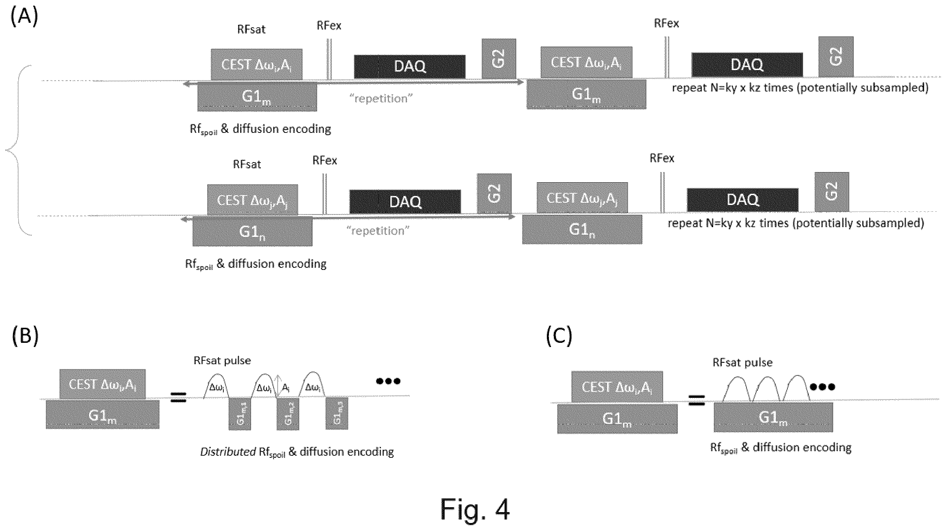

Fig. 4 shows yet a further imaging sequence according to the invention. In Fig. 4(A) a first variant is illustrated, wherein the diffusion encoding gradients are applied concurrently with the CEST encoding off-resonance RF pulses. One advantage is that the timing of the preparation period is not prolonged by separate RF and gradient blocks like in Fig. 3. As the amplitudes of the gradients and the RF vary, the CEST encoding RF may have zero amplitude in some sequence segments and a high amplitude gradient may be applied for diffusion encoding. In Fig 4(B) a specific variant of such imaging sequence is shown, wherein the off-resonance RF is applied as short pulses and also the diffusion encoding gradient is split in short pulses. Such alternating RF and gradient exposure have the advantage that the spatial uniformity of the CEST encoding is not influenced by the diffusion encoding gradients, whilst providing sufficient B1rms for the off-resonance saturation. Another advantage is that the individual RF pulses can have separate RF shim settings to optimize uniformity of the CEST saturation effect. In Fig 4(C) a further variant of the imaging sequence is presented, wherein the CEST encoding is performed by pulsed RF saturation of a high RF duty-cycle while applying a diffusion encoding gradient at the same time. The diffusion gradient leads to position dependent off-resonance effects for the CEST encoding, depending on the gradient strength of the current diffusion encoding step. Taking these into account, Z-spectra can be completed differently for individual positions along the gradient direction over the series of repetitions. This variant is more time efficient and has a high RF duty-cycle.

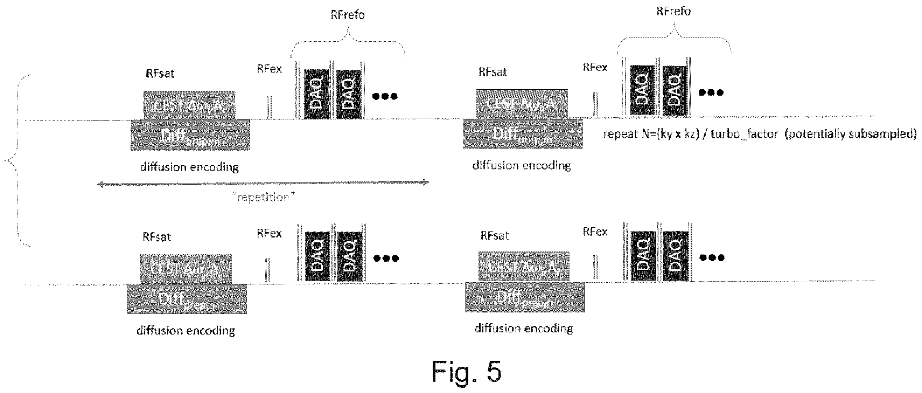

In Fig. 5 a further embodiment of an imaging sequence according to the invention is illustrated, wherein the acquisition is performed using a fast spin echo (FSE) approach (RFex followed by multiple refocusing pulses RFrefo and segmented k-space acquisition with multiple DAQ elements for each refocused echo). The advantage is that there is a higher SNR time-efficiency of the acquisition. Diffusion encoding is combined with CEST encoding as in previous examples. Part of the diffusion encoding (e.g., one lobe of a bipolar diffusion gradient) may be inserted between RFex and RFrefo.

In some embodiments the preparation module that provides off-resonance saturation or diffusion encoding can also be placed prior to a TSE readout. In this case RFex is a 90 degrees pulse and the RFrefo are refocusing pulses which can take any value from 180 degrees (nominal refocusing) to 100 degrees (for SAR reduction and mixing in stimulated echoes at later DAQ). The diffusion encoding as preparation module for TSE sequences typically includes a 90 degrees excitation pulse, a diffusion gradient lobe, a refocusing gradient, another diffusion gradient lobe and a crusher plus a 90 degrees excitation pulse. This scheme is well known as the Alsop diffusion preparation. Alternative preparation schemes may also be applied.

Further, in any embodiment of the single sequence, the diffusion weighted imaging related portion of the sequence may be based on a diffusion weighted imaging with background suppression (DWIBS), applied in the whole body.

In the processing of the concurrently acquired DWI and APTw information with any of the sequence embodiments disclosed above, geometrically precise and accurate combinations can readily be achieved through signal combinations, including the following embodiments:
(i) using DWI -based masking on the APTw data to display (in color scale or greyscale) and evaluate APTw signals only in areas where DWI detects lesions/abnormalities. In one example a color overlay is used, for example DWI as image brightness, APTw as image color, only displayed for pixels where the DWI brightness exceeds a set threshold;
(ii) using APTw-based masking on DWI images to highlight suspected lesions by selecting pixels based on for example APTw signal range or threshold. Such masking can be applied prior to maximum intensity projection (MIP) processing and will then only display in the MIP those voxels in the diffusion encoded dataset where the corresponding voxel in the APTw matches predefined criteria;
(iii) using the combined DWI data (for example a computed apparent diffusion coefficient (ADC) or a synthetic computed high b-value DWI) and APTw data to compute and display composite metrics, like for example: ratio or sum or product of percentage-deviation from normal tissue ADC and APTw values, ADC based correction of APTw values etc.;
(iv) using radiomics approaches (or deep learning models) with a joint DWI and APTw input. Instead of diffusion weighted data, also the computed ADC may serve as input. For example, using radiomics length scale analyses on lesions and display the ratio or Euclidian distance of (a set of) such metrics. Liang HX, et al., The application value of support vector machine model based on multimodal MRI in predicting IDH-1mutation and Ki-67 expression in glioma; BMC Med Imaging; 24(1):244; doi: 10.1186/s12880-024-01414-1 and Yuan J, et al., Structural- and DTI- MRI enable automated prediction of IDH Mutation Status in CNS WHO Grade 2-4 glioma patients: a deep Radiomics Approach; BMC Med Imaging; 24(1): 104; doi: 10.1186/s12880-024-01274-9 are herewith incorporated by reference in their entirety.

Further, processing steps (i) or (ii) can be combined with any of (iii), (iv) and their combination.

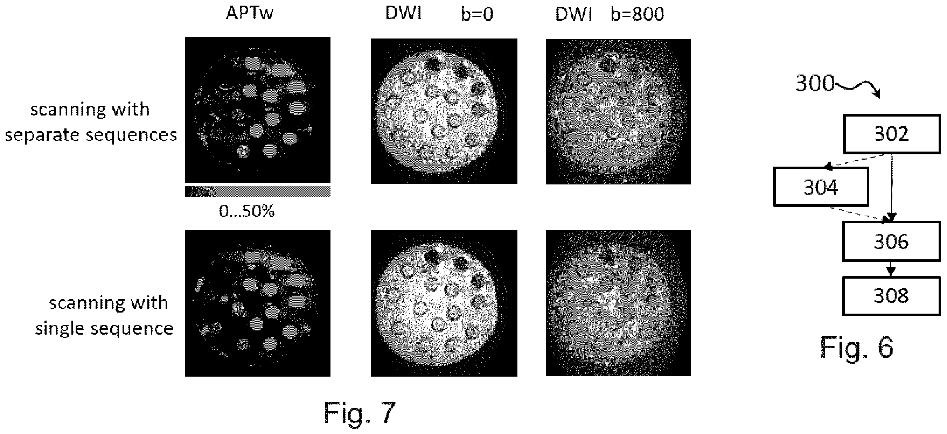

With reference to the flow chart illustrated in Fig. 6, a method 300 of MR imaging is presented.

In step 302 at least a part of the body of a patient is subjected to an imaging sequence according to any of the sequence embodiments (a) to (e).

In step 304, optionally to the sequence used in step 302, it may be inferred magnetic field homogeneity (Bo map) for signal correction from the same combined scan (e.g., using a Dixon-type APT readout to simultaneously provide a B₀ map and/or fat-water information) or include B₀ map data from a separate sequence acquisition. As further alternative or additional option, diffusion weighting may be used only in parts of the APTw Z-spectral acquisition and different diffusion weighting may be used for different parts of the Z-spectral acquisition. In a further alternative or additional option, diffusion weighting may be used in parts of an APTw acquisition with different RF saturation levels (B1rms and/or overall pulse duration).

In step 306, the processing of the received magnetic resonance imaging data of at least one portion of the body subjected to a sequence according to step 302 or additionally with the optional addition of step 304, includes any of the embodiments (i) to (iv). Optionally, the processing according to (i) or (ii) can be combined with any of (iii), (iv) and their combination.

In step 308 the information derived in step 306 is output to a display screen.

Any of the method steps may be computer-implemented such that the computer system may carry out any or all of the method steps according to any of the embodiments of the method disclosed hereinbefore. The memory may comprise computer executable instructions corresponding to algorithms associated with any or all of the method steps, such that execution of the instructions causes the computer system to perform any of the method embodiments according to the invention.

The method according to the invention is presented for illustration purpose with an example.

Fig. 7 shows results of a phantom experiment implementing the method according to the invention, wherein for step 302 the sequence according to embodiment (a) has been used, illustrated in Fig. 2. The phantom comprised different concentrations of Iopamidol prepared at same pH values in the outer ring, and same concentration at different pH in the inner ring. The results from scanning with single sequence having combined APT and DWI readouts (scan time 1.5 min) are almost indistinguishable from the results obtained by scanning with separate individual APT and DWI sequences (APTw scan time of 1.5 min plus an additional DWI scanning time of 30 sec, adding up to 2 min in total).

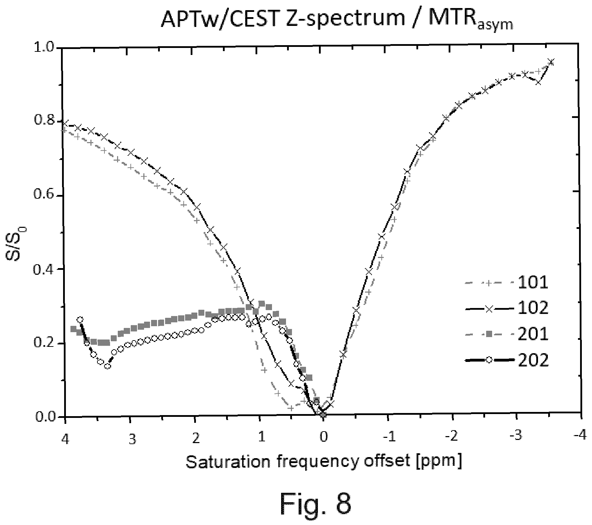

Also, the Z-spectrum and MTR_{asym} analysis on exemplary test tube in Fig. 8 shows only very minor deviations between the results of single sequence scanning according to the invention and the separate APTw and DWI scanning results, throughout the frequency range of ±4 ppm. In Fig. 8, 101 and 201 represent Z-spectrum and MTR_{asym} for the scanning with separate APTw and DWI sequences, while 102 and 202 represent Z-spectrum and MTR_{asym} for the scanning with single sequence according to the invention.

To implement the sequence according to the invention, splitted dynamics were interleaved between the APTw (dynamic scan: single Z-spectral point) and DWI scan (dynamic scan: one average of 3 slices, 2 b-values). A separate gradient echo Dixon scan was used for B₀ mapping.
The following contrast encoding elements and parameters have been used:
for APTw contrast encoding: 2D single-shot TSE, low-high k-space order, α=90°, DRIVE refocusing 120°, FOV (160 mm)², voxel (1.5 mm)², slice 6mm, TR/TE=6500/7.9 ms, B1_{sat,rms}=1.5 µT, RF saturation duration Tₛₐₜ=2 s, pBW=295 Hz, 14 Z-spectral points (±4.2 ppm, ±3.5 ppm, ±2.8 ppm, ±2.1 ppm, ±1.4 ppm, ±0.7 ppm, S0=-1570 ppm);
for diffusion information (DWI) encoding: multi-slice single-shot SE-EPI, same FOV/voxel/slice as (1), 3 slices, α=90°, TR/TE=410/100 ms, SPIR fat suppression, 2 b-values (0,800, b=800 scanned in M/P/S directions), 14 dynamic scans (used for averaging), pBW/EPI-BW 23/2130 Hz;
for B₀ map: 2D FFE, same FOV/ slice, acq. voxel (1.8 mm)², α=30°, 3×multi-acq DIXON, ΔTE=0.5 ms, NSA=12, TR/TE=11/5.4 ms, acquisition time 35 seconds.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

## Claims

1. A method of magnetic resonance imaging at least a portion of a body (10), comprising:
acquiring signals by subjecting the portion of the body to first and second contrast encoding elements within one repetition time, TR, of a sequence, wherein the first contrast encoding elements comprise chemical exchange saturation transfer, CEST, information encoding and the second contrast encoding elements comprise diffusion information encoding;
deriving CEST information based on the signals associated with the first contrast encoding elements;
deriving diffusion information based on the signals associated with the second contrast encoding elements; and
outputting the CEST information and the diffusion information.

2. The method according to claim 1, wherein the second contrast encoding elements are integrated during a delay time after the first contrast encoding elements, within the repetition time of the sequence.

3. The method according to claim 1, wherein at least a portion of one of the first contrast encoding elements at least partially overlaps in timing with at least a portion of one of the second contrast encoding elements.

4. The method according to any of the preceding claims, wherein the repetition time of the sequence comprises multiple repetitions of diffusion encoding elements.

5. The method according to any of the preceding claims, wherein the CEST information encoding comprises CEST saturation at different saturation frequency offsets, Z-frequencies, and/or at different saturation levels, B1rms level of the saturation pulse.

6. The method according to any of the preceding claims, wherein the diffusion information encoding comprises diffusion weighting gradients, the CEST information encoding comprises off-resonance radiofrequency saturation for CEST contrast preparation, and wherein optionally, the diffusion weighting gradients are integrated into pulsed off-resonance radiofrequency, RF, saturation for CEST contrast preparation.

7. The method according to claim 6, wherein the diffusion weighting gradients are implemented as block gradient pulses in multiple directions and/or at different strengths, or elements of an oscillating gradient.

8. The method according to any of the preceding claims, wherein the diffusion information encoding comprises spoiler gradient configured to spoil transverse magnetization from on-resonance radiofrequency excitation for the CEST signal acquisition associated with the CEST information encoding comprising off-resonance radiofrequency saturation.

9. The method according to any of the preceding claims, wherein outputting the CEST information and the diffusion information comprises diffusion information-based masking of CEST information, or CEST-based masking of diffusion information.

10. The method according to any of the preceding claims, wherein outputting comprises displaying and/or evaluating CEST information only in anatomical areas where diffusion information is indicative of lesion or abnormality, or displaying and/or evaluating diffusion information only in anatomical areas where CEST information is indicative of lesion.

11. The method according to any of the preceding claims, wherein outputting the CEST information and the diffusion information comprises a composite metric based on the CEST information and the diffusion information.

12. The method according to any of the preceding claims, wherein the CEST information comprises amide proton transfer weighted information and the diffusion information comprises any of diffusion weighted imaging, diffusion weighted imaging with background suppression, apparent diffusion coefficient, and diffusion kurtosis imaging.

13. The method according to any of the preceding claims, wherein outputting the CEST information and the diffusion information comprises radiomics analyses on lesions, based on combined CEST information and diffusion information.

14. A system comprising:
a magnetic resonance imaging system (1) comprising a computational system (15, 16, 17) for performing a method according to any of claims 1 to 13;
a display screen (18) configured to display the information output by the computational system.

15. A computer program comprising machine executable instructions, wherein execution of the machine executable instructions causes a computational system to control a magnetic resonance imaging system and to perform a method according to any of the claims 1 to 13.
